# EUROPEAN PATENT APPLICATION

(11) **EP 1 513 386 A2**
(43) Date of publication of application: **09.03.2005**
(21) Application number: 04005038.7
(22) Date of filing: 03.03.2004
(51) Int. Cl.: H05K 7/20

(54) **Electronic apparatus**

(30) Priority: 03.09.2003 JP 2003310850
(71) Applicant: Hitachi, Ltd., Chiyoda-ku, Tokyo 101-8010 (JP)
(72) Inventor: Kondo, Yoshihiro, Hitachi Ltd., Intel. Prop. Grp., Chiyoda-ku Tokyo 100-8220 (JP); Nakagawa, Tsuyoshi, Hitachi Ltd., Intel. Prop. Grp, Chiyoda-ku Tokyo 100-8220 (JP)
(74) Representative: Beetz & Partner Patentanwälte

(57) **Abstract**

The present invention relates to an electronic apparatus, having a heat diffusion structure (22) having high efficiency, for corresponding to small-sizing and high-performances of an electronic part (7) therein, a liquid sealing portion (20) is provided on a cover on a side of the electronic part (7), which builds up a water-cooling jacket (15) attached on an upper portion (16) of the electronic part (7). Further, within an inside of this liquid sealing portion (20), a heat diffusion plate (22) is provided, extending from the vicinity of the center of the water-cooling jacket (15) in zigzag manner. With this, heat generated from the electronic part (7) can be spread all over the cover, as a whole, on the side of the electronic part (7), with an aid of the evaporation heat of the liquid. The heat spread can be transmitted into the cooling liquid circulating within a housing (2) thereof, through liquid flow passages (12) of the water-cooling jacket (15), thereby being radiated into the atmosphere from the portion having a large or wide heat radiation area of the housing (2). Further, the heat generated from the electronic parts (7) can be further spread, up to the water-cooling jacket (15) having a wide area.

## Description

### BACKGROUND OF THE INVENTION

The present invention relates to an electronic apparatus having a heat-generation element therein.

Among the electronic apparatuses, comprising a water-cooling system therein, a cooling structure for aiming a high efficiency of the water-cooling jacket is already known, for example, in Japanese Patent Laying-Open No. 2003-21480 (2003).

The structure for receiving and radiating heat, putting a thermo-element between a water-cooling jacket and a plate heat pile, is already known, for example, in Japanese Patent Laying-Open No. 2002-16204 (2002).

Further, in Japanese Patent Laying-Open No. Hei 6-216554 (1994), there is described a technology for cooling a heat-generation element to be used into a part of an electronic appliances or equipments, such as, a printed circuit board, etc., through a metal case made up with a group of flat heat pipes.

However, those of the conventional arts mentioned above relate to the technology of removing the heat generated from an electronic part through circulation of a liquid, but none of those pays the considerations on small-sizing of the electronic apparatus, and also the diffusion of heat with high efficiency, for dealing with an increase of heat-generation density accompanying with high performances thereof.

Namely, with only attaching the water-cooling jacket on the electronic part, it is impossible to spread out the heat over the water-cooling jacket, but rather brings about localization of the temperature thereon, easily.

Further, if putting the thermo-element between the heat pipe and the water-cooling jacket, the heat resistance established upon the contact surface between them; therefore there is also other problem of causing the difference in temperature thereon.

### SUMMARY OF THE INVENTION

An object of the present invention, accordingly, is to provide a heat diffusion structure, having high efficiency for coping or treating with the small-sizing and high-performances of an electronic part in the electronic apparatus.

For accomplishing the object mentioned above, according to the present invention, there is provided an electronic apparatus, comprising: a semiconductor element installed within a housing; a heat-receiving portion for receiving heat generated from said semiconductor element; and a heat radiation portion being connected between said heat radiation portion and said heat-receiving portion through conduits, wherein a heat diffusion plate is provided between said heat-receiving portion and said semiconductor element.

Also, for accomplishing the object mentioned above, according to the present invention, there is provided the electronic apparatus, as described in the above, wherein: said heat diffusion plate is made of a metal defining a hermetically closed space therein, for enclosing evaporation medium within an inside thereof.

Further, for accomplishing the object mentioned above, according to the present invention, there is provided the electronic apparatus as mentioned above, wherein: within the inside of said hermetically close space is attached a metal plate, expanding radial directions from a portion of said semiconductor element.

Also, according to the present invention, for accomplishing the object mentioned above, there is provided the electronic apparatus as mentioned above, wherein: said metal plate is formed zigzagging.

And further, according to the present invention, for accomplishing the object mentioned above, there is provided the electronic apparatus as mentioned above, wherein: said heat-receiving portion comprises four (4) pieces of liquid circulation flow passages within an inside thereof.

And also, for accomplishing the object mentioned above, according to the present invention, there is provided the electronic apparatus as mentioned above, wherein: said liquid circulation flow passages are defined by three (3) pieces of partition walls attached on an interior wall surface of an upper cover for building up said heat-receiving portion.

### BRIEF DESCRIPTION OF THE VARIOUS VIEWS OF THE DRAWING

Those and other objects, features and advantages of the present invention will become more readily apparent from the following detailed description when taken in conjunction with the accompanying drawings wherein:
Fig. 1 is a perspective view of an electronic apparatus, according to a first embodiment of the present invention;
Fig. 2 is an outline view for showing a water-cooling system, according to the first embodiment, in particular, seen from the right-hand side surface thereof;
Fig. 3 is a cross-section view of the water-cooling jacket, according to the first embodiment;
Fig. 4 is A-A cross-section view of the water-cooling jacket shown in Fig. 3 mentioned above;
Fig. 5 is a cross-section view of the water-cooling jacket, according to a second embodiment of the present invention;
Fig. 6 is B-B cross-section view of the water-cooling jacket shown in Fig. 5 mentioned above; and
Fig. 7 is a cross-section view of a liquid sealing portion, according to a third embodiment of the present invention.

### DETAILED DESCRIPTION OF THE INVENTION

Explanation will be given about embodiments according to the present invention, by referring to figures attached herewith.

### [Embodiment 1]

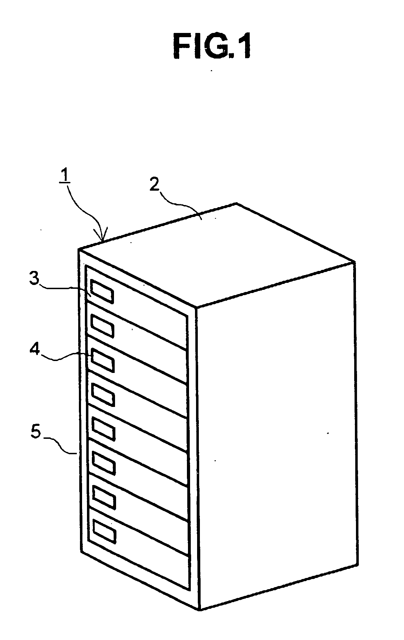

Fig. 1 is a perspective view of an electronic apparatus, according to an embodiment of the present invention.

In Fig. 1, an electronic apparatus 1 is built up with a cabinet 2 and a plural number of electronic apparatus units 3. Each of the electronic apparatus units 3 is provided with a display portion 4 on a front surface 5 thereof, for indicating the apparatus being in the condition of turning electricity or not therethrough (e.g., ON or OFF of power thereof), etc., for example. This electronic apparatus unit is, so-called a server.

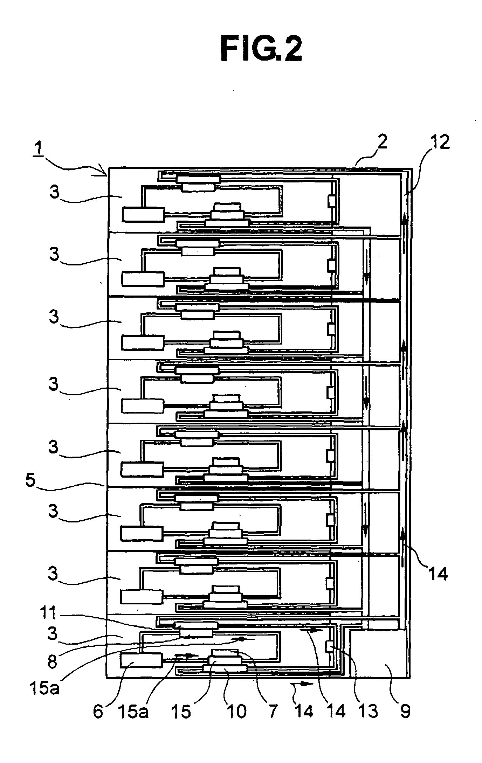

Fig. 2 is an outlook view of the electronic apparatus shown in Fig. 1, but seen from the right-hand side thereof.

In Fig. 2, within an inside of the cabinet 2 building up the electronic apparatus 1, a plural number of the electronic apparatus units 3 are installed in a manner of multi-stages (in the present embodiment, eight (8) stages, for example, and the details of the electronic apparatus unit will be mentioned about only the unit installed at the lowest stage thereof).

Within the electronic apparatus unit 3 is received a CPU 7 (i.e., a semiconductor element) generating heat therefrom. For the purpose of cooling of this CPU 7, a first cooling system is installed, for circulating a liquid for the purpose of cooling thereof.

Explaining the details of this first cooling system, a micro-pump 6, a heat-receiving jacket 15 and also a heat exchanger 8 are connected sequentially, by means of conduits. The heat-receiving jacket 15 is thermally connected to the CPU 7, therefore the heat generated from the CPU 7 is absorbed by means of the heat-receiving jacket 15. The cooling water absorbing the heat therein is driven to circulate within the direction (i.e., the circulation direction of liquid), as indicted by an arrow 15a, with an aid of the function of the micro-pump 6.

While, explaining about the details of a second cooling system, a large-sized pump 9 is attached on a rear side of the cabinet 2. To this large-sized pump 9 is connected a conduit 12. This conduit is inserted into an inside of the electronic apparatus unit 3 at each stage, and at the same time, a conduit 14 rising up from the large-sized pump 9 in parallel with the cabinet 2 is in contact with an interior wall surface of the cabinet 2. Onto the conduit inserted into the inside of the electronic apparatus unit 3 are attached two (2) heat-receiving portions 11 and 12, wherein the heat-receiving portion 10 is thermally connected with the heat-receiving jacket 15 of the first cooling system while the heat-receiving portion 11 is thermally connected with the heat exchanger 8. The cooling liquid discharged from the pump 9 circulates in a direction of an arrow 14, and is collected into the large-sized pump, again, after circulating around the electronic apparatus unit 3 installed at each of the stages.

However, the first and the second cooling systems differ in the circulation direction of the cooling water, as are indicated by the arrows 14 and 15a.

With this, the heat generated from the CPU 7 in each the electronic apparatus unit 3 is transmitted to the cabinet 2 via the conduit 12, and the heat transmitted up to the cabinet 2 is discharged into an atmosphere, through the natural heat radiation upon the cabinet 2, as a whole, or by means of a cooling fan (not shown in the figure), compulsively, which is provided in the cabinet.

Since the first water-cooling system is attached onto each of the electronic apparatus units 3, while also the second water-cooling system is attached onto the cabinet 2, respectively, there is no connection portion of the cooling water between the first water-cooling system and the second water-cooling system. Accordingly, it is possible to eliminate leakage of the cooling water, in particular, when the electronic apparatus unit 3 is attached/detached thereto.

Further, even in a case where one of the first and second water-cooling systems is in trouble and/or stall thereof, assumingly, either one of the water-cooling systems is still on the operation thereof, and therefore, there is no necessity of stopping the electronic apparatus, as a whole. Also, the circulating direction of the cooling water in the first water-cooling system; i.e., the cooling liquid becoming hot due to the heat-generation of the CPU, and the circulating direction of the cooling water in the second water-cooling system, which is mounted on the cabinet 2, they are reversed or opposing to each other; then, the cooling water of the second water-cooling system passes through a high-temperature portion of the electronic apparatus unit 3, and therefore it is possible to mitigate an increase of temperature of the cooling water and also to increase the reliability of the materials of building up the water-cooling system.

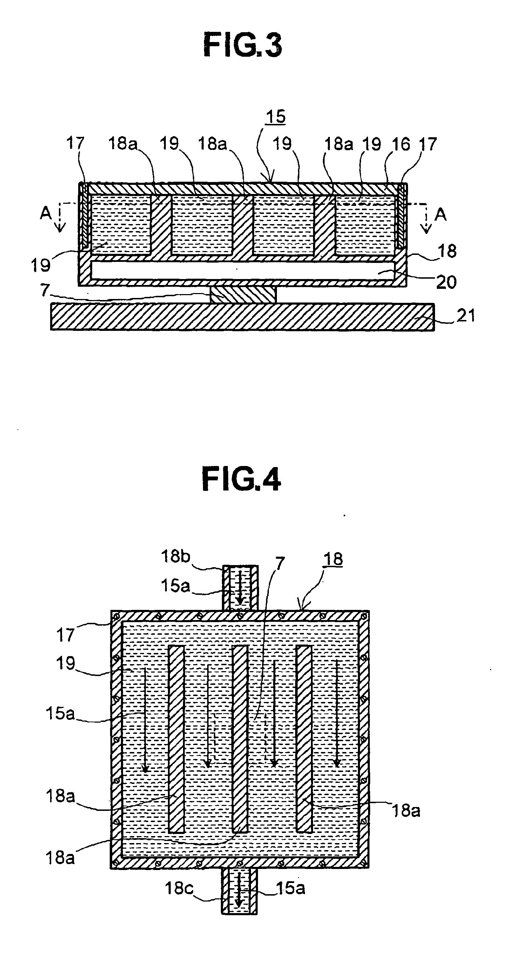

Fig. 3 is a cross-section view for explaining the structure of the water-cooling jacket 15 described in Fig. 2 mentioned above.

Fig. 4 is A-A cross-section view of the water-cooling jacket shown in Fig. 3 mentioned above.

In those Figs. 3 and 4, the heat-receiving jacket 15 is thermally connected with the CPU 7 through heat-conductive grease or the like. The CPU 7 is mounted on an electronic substrate or board 21. The CPU 7, since it is not only coming to be fine due to the high-integration of a semiconductor element; i.e., being small in an external sizes thereof, but also increasing the consumption electric power thereof accompanying with the high-performances thereof, therefore it rises up an amount of heat-generation per a unit of area thereof. For example, it is about 200W per 1 square centimeter.

The heat-receiving jacket 15 is built up with an upper cover 16 and a lower cover 18, wherein onto the upper cover 16 is fixed the lower cover 18 by means of screws 17, which are inserted from tapped holes formed on the upper cover 16 into tapped holes formed on the lower cover 18. Onto the lower cover 18 are formed three (3) pieces of partition walls 18a in one body, and each of tips of the portion wall is closely in contact with an interior wall surface of the upper cover 16. Due to this partition wall 18a, four (4) pieces of flowpassages 19 are formed therewith. Areference numeral 18b depicts a supply opening of the cooling water, while 18c a discharge opening of the cooling water.

With this, as indicated by arrows 15a, the cooling water flows within the four (4) pieces of the flow passages 19, in parallel with, which are defined by the partition walls 18a.

A reference numeral 20 depicts a liquid sealing portion, within which a very small amount of the cooling water is filled up with. This liquid sealing portion 20 carries out the function of so-called a heat pipe. Thus, while one surface thereof is in contact with the CPU, the cooling liquid filled within an inside thereof expands due to the heat generated from the CPU 7, thereby spreading within an inside of the liquid sealing portion 20. With this, the heat of the CPU 7 spreads out over the entire surface of the liquid sealing portion 20. The heat spread is transmits to the cooling liquid within the liquid flow passages 19 of the lower cover 19, and the cooling liquid repeats the following cycle: i.e., being condensed, being liquefied, and turning back to the heat-generation body 7. With an aid of this heat-receiving jacket 15 provided with the liquid sealing portion 20, it is possible to treat with an increase in the density of heat-generation on the heat-generation body 7, thereby enabling cooling down of the heat-generation body 7, with ease.

Although having the liquid sealing portion 20, thereby forming the heat pipe therewith, in Fig. 3, however the portion where the liquid sealing portion 20 is provided may be made from a plate-like member (i.e., a heat diffusion plate) of a material, being very large in the heat conductivity thereof. This heat diffusion plate may be made from a sintered body of carbon, or diamond, for example. In this case, there is no necessity of the space, in which the liquid is enclosed therein; thus, being simple in the structure thereof, and also, it can be obtained with low cost, because of no necessity of enclosing the liquid therein.

### [Embodiment 2]

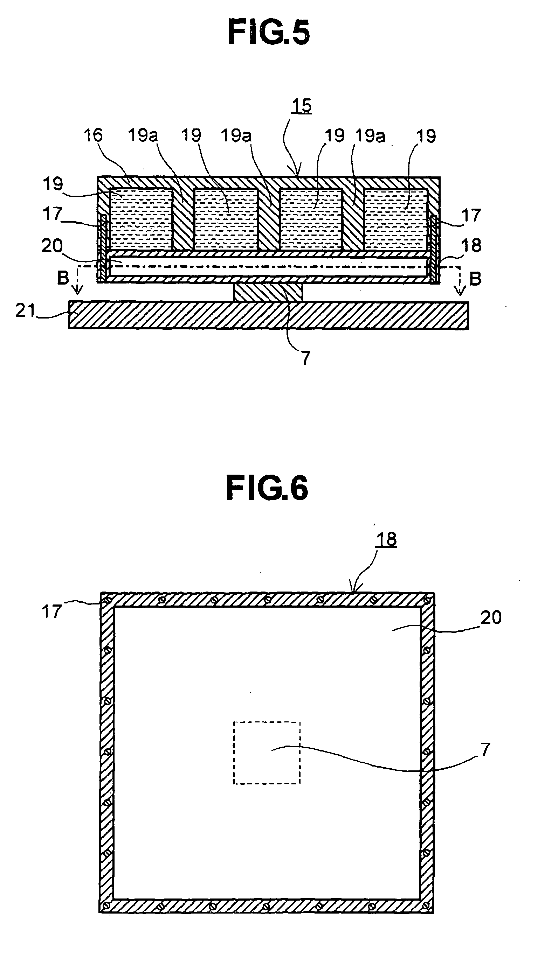

Fig. 5 is a cress-section view of the water-cooling jacket, according to other embodiment.

Fig. 6 is B-B cross-section view of the water-cooling jacket shown in Fig. 5 mentioned above.

In those Figs. 5 and 6, an aspect of the present embodiment differing from the embodiment 1 lies in that the liquid flow passages 19 are formed in the upper cover 16.

The heat-receiving jacket 15 is connected with the CPU, through the heat-conductive grease, etc., thermally. The CPU 7 is mounted on the electronic substrate or board 21.

This heat-receiving jacket 15 is built up with an upper cover 16 and a lower cover 18, wherein onto the upper cover 16 is fixed the lower cover 18 by means of screws 17, which are inserted from tapped holes formed on the upper cover 16 into tapped holes formed on the lower cover 18. Onto the lower cover 18 are formed three (3) pieces of partition walls 18a in one body, and each of tips of the portion wall is closely in contact with an interior wall surface of the upper cover 16. Due to this partition wall 18a, four (4) pieces of flow passages 19 are formed with. Since the circulation route of the cooling liquid is completely same to that explained in relation with Fig. 3 mentioned above, therefore explanation thereof will be omitted herein.

Onto the lower cover 18 is attached the liquid sealing portion 20, explanation of which was given in the above, by referring to Fig. 3 motioned above. This liquid sealing portion 20 is plate-like in the configuration thereof, and has a hermetically sealed space therein, in which a very small amount of the cooling liquid is filled up with. This liquid sealing portion 20 is a means for carry out the function of the heat pile, as was mentioned previously. Thus, being in contact with the CPU 7 on one side surface thereof, the cooling liquid within inside thereof is expanded due to the heat generated from the CPU 7, thereby spreading the heat within the inside of the liquid sealing portion 20. with this, the heat of the CPU 7 spreads all over the entire surface of the liquid sealing portion 20. The heat spreading is transmits to the cooling liquid within the liquid flow passages 19 of the lower cover 19, and the cooling liquid repeats the following cycle: i.e., being condensed, being liquefied, and turning back to the heat-generation body 7. With an aid of this heat-receiving jacket 15 provided with the liquid sealing portion 20, it is possible to treat with the increase in the density of heat-generation of the heat-generation body 7, thereby enabling the cooling down of the heat-generation body 7, with ease.

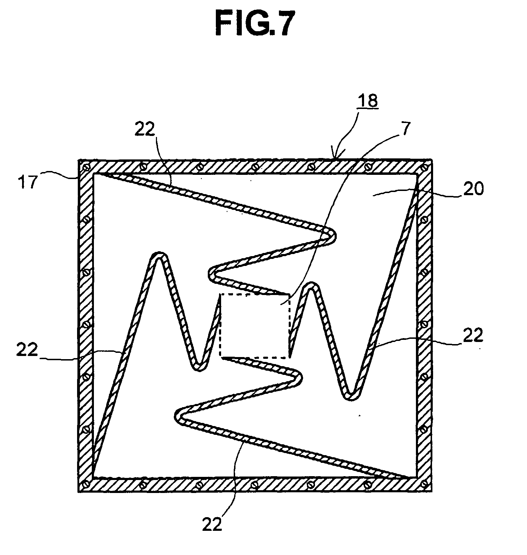

Fig. 7 is a cross-section view of the liquid sealing portion corresponding to the B-B cross-section view shown in Fig. 5 mentioned above.

In this Fig. 7, this embodiment is provided for the purpose of further improving or enhancing the heat diffusion, and wherein a zigzagging heat diffusion plate 22 is extended from an outer edge in the vicinity of the heat-generation body 7 located at a central portion of the lower cover 18, up to an outer peripheral wall surface of the lower cover 18. With an aid of this heat diffusion plate 22, the very small amount of the cooling liquid can flow up to the outer peripheral wall surface of the lower cover 18 along with the heat diffusion plate 22, and further it can also turn back to the heat-generation body, again, therefore it is possible to spread the heat swiftly and uniformly.

In this manner, with provision of the liquid sealing portion on the cover at the side of the electronic part, which builds up the water-cooling jacket attached on an upper portion of the electronic parts in the electronic apparatus, it is also possible to spread out the heat generated from the electronic part all over the cover, as a whole, with an aid of the evaporation heat of the liquid.

The heat spread is transmitted to the cooling liquid circulating within the housing through the liquid flow passage in the water cooling jacket, therefore it can be radiated into the atmosphere from the portion having a large or wide heat radiation area of the housing. Also, with provision of the heat diffusion plate zigzagging from the vicinity of the center of the water cooling jacket, within the inside of the water-cooling jacket, it is possible to spread the heat generated from the electronic parts further to the water-cooling jacket having a wide area.

Also, as was mentioned in the above, according to the present invention, with provision of the liquid sealing portion on the cover at the side of the electronic parts, which builds up the water-cooling system being attached on the upper portion of the electronic parts of the electronic apparatus, the heat generated from the electronic part can be spread out all over the entire of the cover on the side of the electronic parts through the evaporation heat of the liquid. Further, the heat spread can be radiated into the atmosphere from the portion having a large or wide heat radiation area of the housing. Further, with provision of the heat diffusion plate zigzagging from a position in the vicinity of the center of the water-cooling jacket within the inside of the liquid sealing portion of the water-cooling jacket, the heat generated from the electronic parts can be further spread out, up to the water-cooling jacket having a wide area.

As was fully explained in the above, according to the present invention, it is possible to provide an electronic apparatus, enabling the heat diffusion with high efficiency, in coping with the small-sizing and high-performances of the electronic parts thereof.

The present invention may be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. An electronic apparatus, comprising:
a semiconductor element (7) installed within a housing;
a heat-receiving portion (15) for receiving heat generated from said semiconductor element (7); and
a heat radiation portion being connected between said heat radiation portion and said heat-receiving portion (15) through conduits, wherein a heat diffusion plate (22) is provided between said heat-receiving portion (15) and said semiconductor element (7).

2. The electronic apparatus, as described in the claim 1, wherein:
said heat diffusion plate (22) is made of a metal defining a hermetically closed space therein, for enclosing evaporation medium within an inside thereof.

3. The electronic apparatus, as described in the claim 2, wherein:
within the inside of said hermetically close space is attached a metal plate (22), expanding radial directions from a portion of said semiconductor element (7).

4. The electronic apparatus, as described in the claim 3, wherein:
said metal plate (22) is formed zigzagging.

5. The electronic apparatus, as described in the claim 1, wherein:
said heat-receiving portion (15) comprises four (4) pieces of liquid circulation flow passages (19) within an inside thereof.

6. The electronic apparatus, as described in the claim 1, wherein:
said liquid circulation flow passages (19) are defined by three (3) pieces of partition walls (18a) attached on an interior wall surface of an upper cover (16) for building up said heat-receiving portion (15).
